# EUROPEAN PATENT APPLICATION

(11) **EP 4 818 651 A1**
(43) Date of publication of application: **07.10.2026**
(21) Application number: 26168765.1
(22) Date of filing: 27.03.2026
(51) Int. Cl.: G01F 1/69, G01F 15/00, G01F 1/684, G01F 5/00, G01F 15/063

(54) **HIGH-TEMPERATURE MASS FLOW CONTROLLERS AND MASS FLOW SENSORS**

(30) Priority: 01.04.2025 US 202563781744 P; 23.03.2026 US 202619575166
(71) Applicant: Illinois Tool Works Inc., Glenview IL 60025 (US)
(72) Inventor: MUDD, Daniel T., Glenview, 60025 (US); STAUDT, Andrew J., Glenview, 60025 (US); KOTOWSKI, Thomas, Glenview, 60025 (US)
(74) Representative: HGF

(57) **Abstract**

Disclosed example thermal mass flow sensors include: a flow tube having a layer of inorganic insulation on an outer surface of the flow tube; two or more wires wound around corresponding lengths of the flow tube over the inorganic insulation; a heating controller configured to control heating of one or more of the two or more wires; and mass flow measurement circuitry configured to determine a mass flow through the flow tube based on measuring temperatures of two or more of the two or more wires.

## Description

### RELATED APPLICATIONS

The present application claims the benefit of U.S. Provisional Patent Application Serial No. 63/781,744, filed April 1, 2025, entitled "HIGH-TEMPERATURE MASS FLOW CONTROLLERS AND MASS FLOW SENSORS." The entirety of U.S. Provisional Patent Application Serial No. 63/781,744 is expressly incorporated herein by reference.

### FIELD OF THE DISCLOSURE

This disclosure relates to mass flow control and measurement and, more particularly, to high-temperature mass flow controllers and mass flow sensors.

### BACKGROUND

A mass flow controller (MFC) is a device for controlling the flow of fluid through a flow path based on a desired flow rate and real-time feedback measurements of flow rate of the fluid. In order to control this process and maintain the desired flow rate the mass flow controller electromechanically controls the opening and closing of a valve to achieve the desired flow rates according to the feedback measurements.

### SUMMARY

High-temperature mass flow controllers and mass flow sensors are disclosed, substantially as illustrated by and described in connection with at least one of the figures.

### BRIEF DESCRIPTION OF THE DRAWINGS

The benefits and advantages of the present disclosure will become more readily apparent to those of ordinary skill in the relevant art after reviewing the following detailed description and accompanying drawings, wherein:
FIG. 1 is a block diagram of an example mass flow controller, in accordance with aspects of this disclosure.
FIGS. 2A and 2B illustrate an example flow tube and wires that may be used to implement the thermal mass flow sensor of FIGS. 2A and 2B.
FIG. 3 is a block diagram of an example computing device that may be used to implement the valve control circuitry of FIG. 1.

The figures are not necessarily to scale. Where appropriate, similar or identical reference numbers are used to refer to similar or identical components.

### DETAILED DESCRIPTION

Mass flow controllers are used to measure and control the flow of gases, such as gases used in the fabrication of semiconductor devices. The wide variety of processes for fabricating semiconductors continue to move toward reductions in size and cost, while improving performance. To this end, semiconductor fabrication is moving to use materials that involve using higher temperatures and/or lower pressures to use in vapor form. Accordingly, there is a need for mass flow control at lower pressures and higher temperatures than the operating range of conventional MFCs.

Conventional MFCs use one of two primary classes of techniques to measure mass flow. The first class of techniques involve thermal-based techniques which measure mass flow by the energy needed to heat the flow of gas. As mass flow increases, more energy is needed to heat the flowing gas. The second class of techniques are pressure-based techniques, which measure mass flow by measuring the gas temperature and pressures before and after a characterized restriction. Pressure-based MFCs require significantly higher pressures than thermal-based MFC's. The and the magnitude of the pressure drop required during measurements limits the use of pressure-based MFCs at the lower pressures needed for many vapors.

Thermal MFCs have a lower pressure drop requirement for measuring mass flow. When combined with a larger, low pressure drop control valve, thermal MFCs have an extended the practical operating pressure range. However, conventional MFCs have a limited operating temperature range which limits use with materials that require higher temperatures for vaporization. Conventional MFCs use components which are insulated using organic electrical insulation, which limits the operating temperature range of the conventional MFCs. While the organic electrical insulation used in some conventional MFCs is capable of withstanding temperatures up to 200°C, the additional heating provided by the heating coils or wires of the thermal mass flow sensor (e.g., approximately 80°C above ambient temperature) exceeds the temperature limits of the organic electrical insulation in high temperature applications (e.g., 200°C ambient temperature), leading to electrical insulation breakdown and instability of the MFC.

Disclosed example mass flow sensors and MFCs provide higher operating temperature ranges than conventional MFCs and mass flow sensors. In disclosed examples, the characterized flow tube includes a layer of inorganic electrical insulation, which prevents short circuits between the flow tube and the wire windings used for heating and/or sensing. Conventional MFCs and mass flow sensors would suffer from breakdown or other failure of the organic (e.g., polyimide) insulation used to electrically insulate the wire windings and/or the flow tube.

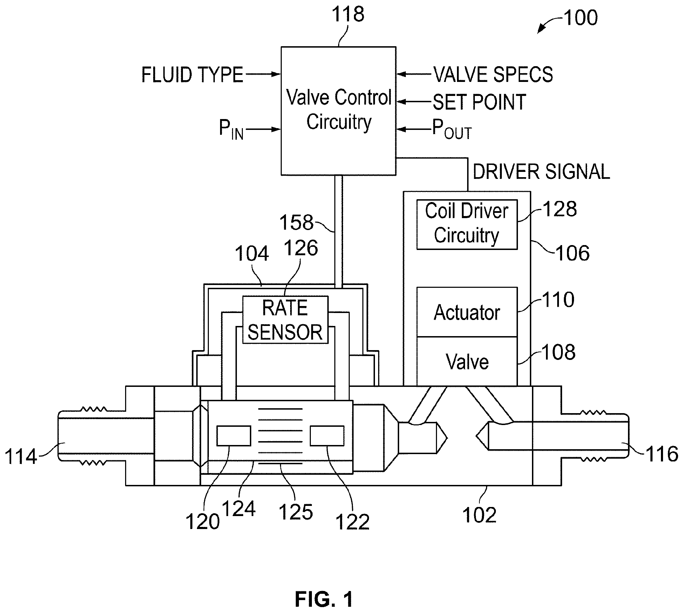

FIG. 1 is a block diagram of an example mass flow controller (MFC) 100. The example MFC 100 includes a base 102, a mass flow meter 104, and a valve assembly 106. The mass flow meter 104 and the valve assembly 106 are mounted on the base 102. The base 102 may further include a fluid inlet 114 and a fluid outlet 116. The MFC controls the flow of gas from the fluid inlet 114 to the fluid outlet 116. While the example MFC 100 is illustrated as having the mass flow meter 104 upstream of the valve assembly 106 (e.g., the mass flow meter 104 is positioned between the valve assembly 106 and the valve inlet 114).

The example valve assembly 106 includes a valve 108 and actuator 110. The valve 108 is actuated by the actuator 110 to control a flow of the gas from the fluid inlet 114 to the fluid outlet 116. The example valve assembly 106 may be a normally-open or normally-closed valve. Because the MFC 100 is configured to operate at ambient temperatures of 200°C, 240°C, 300°C, or above, the actuator 110 may be thermally insulated from the ambient environment and/or include liquid cooling.

The MFC 100 includes an upstream pressure transducer 120 configured to measure a pressure at an upstream position (e.g., upstream of the rate sensor 126 and the bypass restrictor 125) and a downstream pressure transducer 122 configured to measure a pressure at a downstream position (e.g., downstream of the rate sensor 126 and the bypass restrictor 125).

The example MFC 100 further includes valve control circuitry 118 communicatively coupled to the mass flow meter 104 and the valve assembly 106. The valve control circuitry 118 includes a processor, which may be a general-purpose central processing unit (CPU). In some examples, the valve control circuitry 118 may be implemented using, or include, one or more specialized processing units, such as FPGA, RISC processors with an ARM core, graphic processing units, digital signal processors, and/or system-on-chips (SoC). The valve control circuitry 118 executes machine-readable instructions that may be stored locally at the valve control circuitry 118 (e.g., in an included cache or SoC), in a random access memory (or other volatile memory), in a read-only memory (or other non-volatile memory such as FLASH memory), and/or in a mass storage device. Example mass storage devices include a hard drive, a solid-state storage drive, a hybrid drive, a RAID array, and/or any other mass data storage device.

The example mass flow meter 104 is a thermal-type flow meter. The example mass flow meter 104 of FIG. 1 includes a bypass channel 124 having a bypass restrictor 125, through which a portion of the fluid flows and another channel with a flow rate sensor 126 through which a smaller portion of the fluid flows. The valve control circuitry 118 receives measurement signals (e.g., signals representative of flow rate, or signals representative of temperature or power that may be used to calculate flow rate) from the mass flow meter 104.

In operation, as fluid flows past the flow rate sensor 126, the flow rate sensor 126 measures and provides real-time flow rate data (e.g., temperature data, power data, etc.) to the valve control circuitry 118. The flow rate of the fluid can be sensitive and a number of operating conditions including fluid type, upstream and downstream pressure, temperature, flow rate set point value, and valve operating characteristics all can affect the fluid flow rate, i.e. cause a deviation in the rate from a desired set rate. The valve control circuitry 118 controls operation of the valve assembly 106 (e.g., in real-time) by providing an error-correcting drive signal to the valve actuator 110 to adjust the position of the valve 108. The change in the position of the valve 108 controls the flow rate. The valve control circuitry 118 may use factors such as the fluid type, upstream and downstream pressure transducer readings, a flow rate set point value, valve specifications, and/or valve calibration data to control the operation of the valve 108. In some examples, the valve control circuitry 118 uses closed-loop control, such as proportional control, integral control, proportional-integral (PI) control, derivative control, proportional-derivative (PD) control, integral-derivative (ID) control, proportional-integral-derivative (PID) control, and/or any other types of closed-loop or feedback-based control, to control the flow of fluid in the MFC 100.

The example flow rate sensor 126 may be a two-wire type or a three-wire type of flow rate sensor. Example two-wire type thermal flow rate sensors may include current-controlled (e.g., target current, target power) mass flow sensors that measure flow rate as a function of a difference in temperature (or voltage) between two wire windings, and temperature-controlled (e.g., target temperature) mass flow sensors that measure flow rate as a function of the current or power consumed to keep the upstream and downstream wire windings at a target temperature or temperature gradient. Current-controlled thermal mass flow sensors may include a small diameter capillary tube with temperature-sensitive coils formed from winding wire around the tube in two locations. When current is provided to the coils, the coils self-heat, thereby raising both the temperature of the coils and the local section of the flow tube. When gas flows through the sensor, the gas has a preferential cooling effect on the upstream coil, as the gas is predominantly heated by the warm tube local to the upstream coil. The temperature difference between the upstream coil and the downstream coil is indicative for flow through the tube. A higher flow creates a higher cooling effect and a larger resulting signal. Temperature-controlled mass flow sensors vary the power to each wire winding to maintain both coils at an average constant target temperature. The difference in power provided to the two coils is proportional to flow, and the power difference is used to measure the mass flow. Example implementations of the two-wire type thermal flow rate sensors are described in U.S. Patent No. 6,845,659 (John Michael Lull). The entirety of U.S. Patent No. 6,845,659 is incorporated herein by reference.

Example three-wire type thermal flow rate sensors include a center wire winding that provides heating, and the flow rate is measured as a function of the temperature difference between the upstream and downstream wire windings. Example implementations of the three-wire type thermal flow rate sensors are described in U.S. Patent No. 5,944,048 (Bump et al.). The entirety of U.S. Patent No. 5,944,048 is incorporated herein by reference.

In some examples, the flow rate sensor 126 uses a hybrid approach to determining the mass flow, in which the target wire temperatures are a function of the ambient temperature. The power needed to hold the target temperature at different flows determines the mass flow. The hybrid approach adjusts the target temperature by taking into account the changing conductivity of air, the flow tube material, and/or the wire material, which could affect the transfer of heat from the wire(s) to the flowing fluid and/or from the fluid to the sensing wires.

In some examples, the valve control circuitry 118 includes an operator interface (e.g., one or more operator input device(s) and/or operator output device(s)) and/or a communication interface (e.g., wired and/or wireless communications circuitry) to receive commands, configuration variables, setpoints (e.g., a flow rate setpoint), gas characteristics, and/or other data. The operator interface and/or the communication interface may further output data for viewing by an operator and/or to one or more external devices.

While the mass flow meter 104 of FIG. 1 is part of the MFC 100, in other examples the mass flow meter 104 may be a separate device configured to measure mass flow through a flow tube, and output the measured mass flow to an external device.

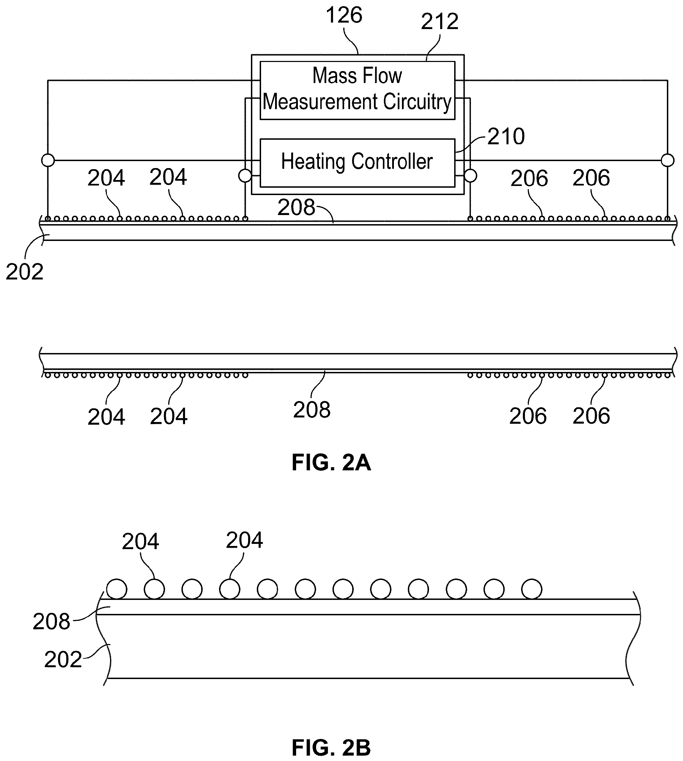

FIG. 2A illustrates an example flow tube 202 and wire windings 204, 206 that may be used to implement the flow rate sensor 126 of FIG. 1. FIG. 2B is a more detailed illustration of a portion of the example flow tube and the wire winding 206. While the example flow tube 202 and wire windings 204, 206 are illustrated as a two-wire type of thermal mass flow sensor, the illustrated example may be adapted to three-wire types of thermal mass flow sensors.

To improve an operating temperature range of the flow tube above conventional mass flow sensors, an exterior surface of the example flow tube 202 is coated in a layer 208 of inorganic insulation. The inorganic insulation layer 208 may be a ceramic, such as a silica-based ceramic material. However, the inorganic insulation layer 208 may be implemented using alumina-based ceramics, inorganic aerogels, fiberglass, mica, and/or any other inorganic thermal insulators that allow for the desired thickness and electrical insulation may be used. The inorganic insulation layer 208 may be applied to the flow tube 202 via plasma jet spray or any other application method.

The wire windings 204, 206 of FIGS. 2A and 2B are bare wires wound directly onto the inorganic insulation layer 208. The wire windings 204, 206 may be wound at a pitch of 1.3 times the diameter used in the wire windings 204, 206. In other examples, the wire windings 204, 206 may be wound at a pitch as low as 1.1 times the diameter used in the wire windings 204, 206 (e.g., based on a level of control of the winding process to avoid turn-to-turn short circuits) or as much as 2 times, or more, the diameter used in the wire windings 204, 206. In some examples, the flow tube 202 or the inorganic insulation layer 208 may be formed with helical grooves to guide the wire winding process and reduce or eliminate shifting of the wire windings 204, 206 that could result in short circuiting between turns of one of the wire windings 204, 206. Additionally or alternatively, the wire windings 204, 206 may be coupled to the inorganic insulation layer 208 using a high-temperature adhesive to reduce or prevent shifting of the wire windings 204, 206.

In some examples, the wire windings 204, 206 have organic insulation at the time of the winding process. The example flow tube 202 and the wire windings 204, 206 may then be thermally processed at a high temperature (e.g., 500° C), which burns off the wire insulation to result in a desired winding pitch but does not adversely affect the inorganic insulation layer 208. The thermal processing may also relieve stress in the wire windings 204, 206 to reduce shifting. Even if the wire windings 204, 206 are not subjected to thermal processing, the inorganic insulation layer 208 prevents failure of the thermal mass flow sensor in the event of a failure of the organic wire insulation during operation.

In contrast with conventional thermal mass flow sensors, the disclosed example flow rate sensor 126 including the inorganic insulation layer 208 is capable of continuous use at ambient temperatures of at least 200°C. Some such flow rate sensors 126 are capable of continuous use at ambient temperatures of at least 240°C, and/or capable of continuous use at ambient temperatures of at least 300°C, taking into account the additional heating of the inorganic insulation layer 208 by one or more of the wire windings 204, 206 above the ambient temperature.

The example wire windings 204, 206 may be coupled to a heating controller 210 to control heating of one or more of the wire windings 204, 206 (e.g., both wire windings 204, 206 in a two-wire type sensor, one of the wire windings 204, 206 in a three-wire type sensor including a third wire). The example wire windings 204, 206 are further coupled to mass flow measurement circuitry 212. The mass flow measurement circuitry 212 determines the mass flow through the flow tube 202 based on measuring heating of the wire windings 204, 206 using the two-wire type sensor techniques or the three-wire type sensor techniques discussed above.

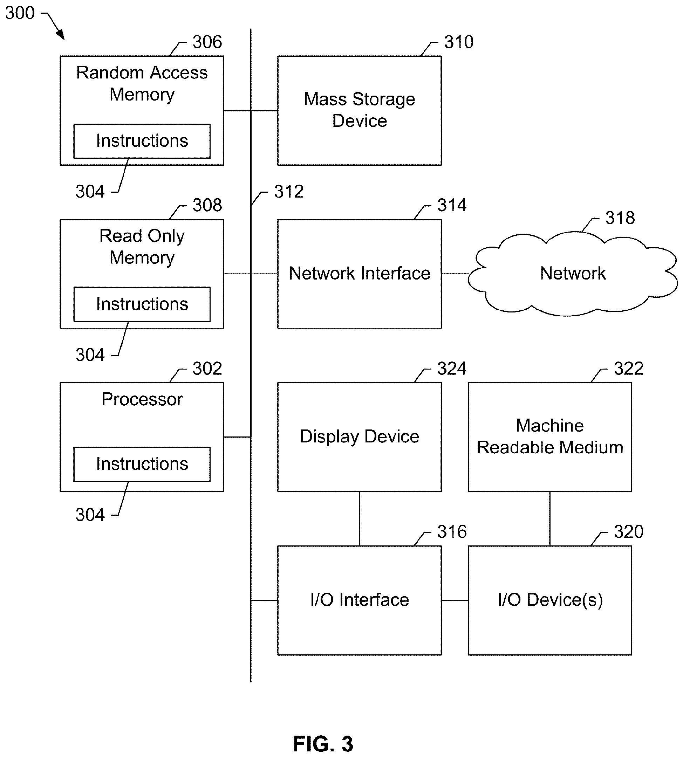

FIG. 3 is a block diagram of an example computing device 300 that may be used to implement the valve control circuitry 118 of FIG. 1. The example computing device 300 may be a general-purpose computer, a laptop computer, a tablet computer, a mobile device, a server, an all-in-one computer, and/or any other type of computing device. The computing device 300 of FIG. 3 includes a processor 302, which may be a general-purpose central processing unit (CPU). In some examples, the processor 302 may include one or more specialized processing units, such as FPGA, RISC processors with an ARM core, graphic processing units, digital signal processors, and/or system-on-chips (SoC). The processor 302 executes machine-readable instructions 304 that may be stored locally at the processor (e.g., in an included cache or SoC), in a random access memory 306 (or other volatile memory), in a read-only memory 308 (or other non-volatile memory such as FLASH memory), and/or in a mass storage device 310. The example mass storage device 310 may be a hard drive, a solid-state storage drive, a hybrid drive, a RAID array, and/or any other mass data storage device. A bus 312 enables communications between the processor 302, the RAM 306, the ROM 308, the mass storage device 310, a network interface 314, and/or an input/output interface 316.

An example network interface 314 includes hardware, firmware, and/or software to connect the computing device 300 to a communications network 318 such as the Internet. For example, the network interface 314 may include IEEE 802.X-compliant wireless and/or wired communications hardware for transmitting and/or receiving communications.

An example I/O interface 316 of FIG. 3 includes hardware, firmware, and/or software to connect one or more input/output devices 320 to the processor 302 for providing input to the processor 302 and/or providing output from the processor 302. For example, the I/O interface 316 may include a graphics-processing unit for interfacing with a display device, a universal serial bus port for interfacing with one or more USB-compliant devices, a FireWire, a field bus, and/or any other type of interface. The example computing device 300 may include a display device 324 (e.g., an LCD screen) coupled to the I/O interface 316. Other example I/O device(s) 320 may include a keyboard, a keypad, a mouse, a trackball, a pointing device, a microphone, an audio speaker, a display device, an optical media drive, a multi-touch touch screen, a gesture recognition interface, a magnetic media drive, and/or any other type of input and/or output device.

The computing device 300 may access a non-transitory machine-readable medium 322 via the I/O interface 316 and/or the I/O device(s) 320. Examples of the machine-readable medium 322 of FIG. 3 include optical discs (e.g., compact discs (CDs), digital versatile/video discs (DVDs), Blu-ray discs, etc.), magnetic media (e.g., floppy disks), portable storage media (e.g., portable flash drives, secure digital (SD) cards, etc.), and/or any other type of removable and/or installed machine-readable media.

The present methods and systems may be realized in hardware, software, and/or a combination of hardware and software. The present methods and/or systems may be realized in a centralized fashion in at least one computing system, or in a distributed fashion where different elements are spread across several interconnected computing systems. Any kind of computing system or other apparatus adapted for carrying out the methods described herein is suited. A typical combination of hardware and software may include a general-purpose computing system with a program or other code that, when being loaded and executed, controls the computing system such that it carries out the methods described herein. Another typical implementation may comprise an application specific integrated circuit or chip. Some implementations may comprise a non-transitory machine-readable (e.g., computer-readable) medium (e.g., FLASH drive, optical disk, magnetic storage disk, or the like) having stored thereon one or more lines of code executable by a machine, thereby causing the machine to perform processes as described herein. As used herein, the term "non-transitory machine-readable medium" is defined to include all types of machine-readable storage media and to exclude propagating signals.

As utilized herein the terms "circuits" and "circuitry" refer to physical electronic components (i.e. hardware) and any software and/or firmware ("code") which may configure the hardware, be executed by the hardware, and or otherwise be associated with the hardware. As used herein, for example, a particular processor and memory may comprise a first "circuit" when executing a first one or more lines of code and may comprise a second "circuit" when executing a second one or more lines of code. As utilized herein, "and/or" means any one or more of the items in the list joined by "and/or". As an example, "x and/or y" means any element of the three-element set {(x), (y), (x, y)}. In other words, "x and/or y" means "one or both of x and y". As another example, "x, y, and/or z" means any element of the seven-element set {(x), (y), (z), (x, y), (x, z), (y, z), (x, y, z)}. In other words, "x, y and/or z" means "one or more of x, y and z". As utilized herein, the term "exemplary" means serving as a non-limiting example, instance, or illustration. As utilized herein, the terms "e.g.," and "for example" set off lists of one or more non-limiting examples, instances, or illustrations. As utilized herein, circuitry is "operable" to perform a function whenever the circuitry comprises the necessary hardware and code (if any is necessary) to perform the function, regardless of whether performance of the function is disabled or not enabled (e.g., by a user-configurable setting, factory trim, etc.).

While the present method and/or system has been described with reference to certain implementations, it will be understood by those skilled in the art that various changes may be made and equivalents may be substituted without departing from the scope of the present method and/or system. In addition, many modifications may be made to adapt a particular situation or material to the teachings of the present disclosure without departing from its scope. For example, systems, blocks, and/or other components of disclosed examples may be combined, divided, re-arranged, and/or otherwise modified. Therefore, the present method and/or system are not limited to the particular implementations disclosed. Instead, the present method and/or system will include all implementations falling within the scope of the appended claims, both literally and under the doctrine of equivalents.

Certain embodiments of the invention are described in the following clauses:
Clause 1. A thermal mass flow sensor, comprising:
   a flow tube having a layer of inorganic insulation on an outer surface of the flow tube;
   two or more wires wound around corresponding lengths of the flow tube over the inorganic insulation;
   a heating controller configured to control heating of one or more of the two or more wires; and
   mass flow measurement circuitry configured to determine a mass flow through the flow tube based on measuring temperatures of two or more of the two or more wires.
Clause 2. The thermal mass flow sensor as defined in clause 1, wherein the two or more wires are uninsulated wires wrapped directly on the inorganic insulation.
Clause 3. The thermal mass flow sensor as defined in clause 1, wherein the inorganic insulation is capable of continuous use at at least 200° Celsius ambient temperature.
Clause 4. The thermal mass flow sensor as defined in clause 3, wherein the inorganic insulation is capable of continuous use at at least 240° Celsius ambient temperature.
Clause 5. The thermal mass flow sensor as defined in clause 4, wherein the inorganic insulation is capable of continuous use at at least 300° Celsius ambient temperature.
Clause 6. The thermal mass flow sensor as defined in clause 1, wherein the inorganic insulation comprises a helical groove, at least one of the first wire and the second wire being disposed within the helical groove.
Clause 7. The thermal mass flow sensor as defined in clause 1, wherein the inorganic insulation comprises a ceramic.
Clause 8. The thermal mass flow sensor as defined in clause 1, wherein the mass flow measurement circuitry is configured to determine the mass flow based on at least one of a temperature difference between two or more of the two or more wires or a difference in power consumed to maintain the two or more of the two or more wires at a target temperature.
Clause 9. A mass flow controller, comprising:
   a thermal mass flow sensor, comprising:
      a flow tube having a layer of inorganic insulation on an outer surface of the flow tube;
      two or more wires wound around corresponding lengths of the flow tube over the inorganic insulation;
      a heating controller configured to control heating of one or more of the two or more wires; and
      mass flow measurement circuitry configured to determine a mass flow through the flow tube based on measuring heating of two or more of the two or more wires; and
   a flow valve configured to control, based on the mass flow determined by the thermal mass flow sensor, flow between the flow tube and at least one of an inlet or an outlet.
Clause 10. The mass flow controller as defined in clause 9, wherein the two or more wires are uninsulated wire wrapped directly on the inorganic insulation.
Clause 11. The mass flow controller as defined in clause 10, wherein a first wire of the two or more wires is wrapped at a pitch of at least 1.1 times a diameter of the first wire, and a second wire of the two or more wires is wrapped at a pitch of at least 1.1 times a diameter of the second wire.
Clause 12. The mass flow controller as defined in clause 9, wherein the inorganic insulation is capable of continuous use at at least 200° Celsius ambient temperature.
Clause 13. The mass flow controller as defined in clause 12, wherein the inorganic insulation is capable of continuous use at at least 240° Celsius ambient temperature.
Clause 14. The mass flow controller as defined in clause 13, wherein the inorganic insulation is capable of continuous use at at least 300° Celsius ambient temperature.
Clause 15. The mass flow controller as defined in clause 9, wherein the mass flow measurement circuitry is configured to determine the mass flow based on at least one of a temperature difference between the first wire and the second wire or a difference in power consumed to maintain the first wire and the second wire at a target temperature.
Clause 16. The mass flow controller as defined in clause 9, wherein the flow valve comprises an actuator, the actuator being thermally insulated from an ambient environment.
Clause 17. The mass flow controller as defined in clause 9, wherein the inorganic insulation comprises a helical groove, at least one of the first wire and the second wire being disposed within the helical groove.

## Claims

1. A thermal mass flow sensor, comprising:
a flow tube having a layer of inorganic insulation on an outer surface of the flow tube;
two or more wires wound around corresponding lengths of the flow tube over the inorganic insulation;
a heating controller configured to control heating of one or more of the two or more wires; and
mass flow measurement circuitry configured to determine a mass flow through the flow tube based on measuring temperatures of two or more of the two or more wires.

2. The thermal mass flow sensor as defined in claim 1, wherein the two or more wires are uninsulated wires wrapped directly on the inorganic insulation.

3. The thermal mass flow sensor as defined in claim 1 or claim 2, wherein the inorganic insulation is capable of continuous use at at least 200° Celsius ambient temperature.

4. The thermal mass flow sensor as defined in claim 3, wherein the inorganic insulation is capable of continuous use at at least 240° Celsius ambient temperature, for example
wherein the inorganic insulation is capable of continuous use at at least 300° Celsius ambient temperature.

5. The thermal mass flow sensor as defined in any one of claims 1 to 4, wherein the inorganic insulation comprises a helical groove, at least one of the first wire and the second wire being disposed within the helical groove.

6. The thermal mass flow sensor as defined in any one of claims 1 to 5, wherein the inorganic insulation comprises a ceramic.

7. The thermal mass flow sensor as defined in any one of claims 1 to 6, wherein the mass flow measurement circuitry is configured to determine the mass flow based on at least one of a temperature difference between two or more of the two or more wires or a difference in power consumed to maintain the two or more of the two or more wires at a target temperature.

8. A mass flow controller, comprising:
a thermal mass flow sensor, comprising:
a flow tube having a layer of inorganic insulation on an outer surface of the flow tube;
two or more wires wound around corresponding lengths of the flow tube over the inorganic insulation;
a heating controller configured to control heating of one or more of the two or more wires; and
mass flow measurement circuitry configured to determine a mass flow through the flow tube based on measuring heating of two or more of the two or more wires; and
a flow valve configured to control, based on the mass flow determined by the thermal mass flow sensor, flow between the flow tube and at least one of an inlet or an outlet.

9. The mass flow controller as defined in claim 8, wherein the two or more wires are uninsulated wire wrapped directly on the inorganic insulation.

10. The mass flow controller as defined in claim 9, wherein a first wire of the two or more wires is wrapped at a pitch of at least 1.1 times a diameter of the first wire, and a second wire of the two or more wires is wrapped at a pitch of at least 1.1 times a diameter of the second wire.

11. The mass flow controller as defined in any one of claims 8 to 10, wherein the inorganic insulation is capable of continuous use at at least 200° Celsius ambient temperature.

12. The mass flow controller as defined in claim 11, wherein the inorganic insulation is capable of continuous use at at least 240° Celsius ambient temperature, for example
wherein the inorganic insulation is capable of continuous use at at least 300° Celsius ambient temperature.

13. The mass flow controller as defined in any one of claims 8 to 12, wherein the mass flow measurement circuitry is configured to determine the mass flow based on at least one of a temperature difference between the first wire and the second wire or a difference in power consumed to maintain the first wire and the second wire at a target temperature.

14. The mass flow controller as defined in any one of claims 8 to 13, wherein the flow valve comprises an actuator, the actuator being thermally insulated from an ambient environment.

15. The mass flow controller as defined in any one of claims 8 to 14, wherein the inorganic insulation comprises a helical groove, at least one of the first wire and the second wire being disposed within the helical groove.
